# FASCICULE DE BREVET EUROPEEN

(11) **EP 0 836 751 B1**
(45) Date de publication et mention de la délivrance du brevet: **19.07.2000**
(21) Numéro de dépôt: 97919426.3
(22) Date de dépôt: 27.03.1997
(51) Int. Cl.: H01L 35/30, H01L 35/32

(54) **GENERATEUR THERMOELECTRIQUE**
THERMOELEKTRISCHER GENERATOR
THERMOELECTRIC GENERATOR

(30) Priorité: 04.04.1996 FR 9604228
(43) Date de publication de la demande: 22.04.1998
(73) Titulaire: ETAT FRANCAIS représenté par le DELEGUE GENERAL pour L'ARMEMENT, 75007 Paris (FR)
(72) Inventeur: OUDOIRE, Philippe, F-50340 Les Pieux (FR); MESNIL, Tony, F-50110 Tourlaville (FR); DUBOURDIEU, Philippe, F-50100 Cherbourg (FR); TRIBOU, Géry, F-50120 Equeurdreville-Hainneville (FR); BURNOUF, Gérard, F-50120 Equeurdreville-Hainneville (FR)
(86) Numéro de dépôt international: FR9700548
(87) Numéro de publication internationale: WO9738451

(56) Documents cités:
- US-A- 3 097 027
- US-A- 3 794 527
- US-A- 4 292 579
- US-A- 5 228 923

## Description

La présente invention concerne un générateur électrique, du type comprenant des modules thermoélectriques à semi-conducteur, utilisant l'effet Seebeck, et particulièrement un générateur électrique sous-marin pour équiper des têtes de puits de forage.

Pour l'alimentation électrique des équipements (vannes, instrumentation, etc) de puits de forage pétroliers, on connaît de tels générateurs électriques utilisant l'effet thermoélectrique provoqué par la différence de température entre les produits extraits, à savoir des huiles, présentant une température relativement élevée (supérieure à 40°C), qui s'écoulent dans une canalisation de forage ou pipe, et le milieu sous-marin entourant cette canalisation à une température très inférieure, de l'ordre de quelques degrés. Des nappes de thermoéléments sont disposées concentriquement en manchons le long du pipe et reliées électriquement en série ou en parallèle pour produire une alimentation électrique. Les surfaces d'échange thermique de ces modules sont tangentielles par rapport à la section circulaire de la canalisation.

Cette disposition limite le nombre de modules pouvant être disposés par unité de longueur de canalisation. Ainsi, on ne peut guère disposer que de huit modules, sur des pipes de dimension standard, par exemple d'un diamètre de 150 mm. Il en résulte que la puissance électrique fournie par un tel générateur est notablement réduite.

Un autre inconvénient de ce montage réside dans le fait qu'il ne garantit pas la tenue en pression des modules thermoélectriques lorsque le générateur est immergé à grande profondeur, jusqu'à 2 000 m sur certains sites.

Enfin, les échanges thermiques à l'intérieur de la canalisation ne sont pas optimisés.

La présente invention remédie à ces inconvénients en proposant un générateur thermoélectrique qui peut fournir une puissance électrique accrue et qui peut être immergé à de grandes profondeurs, par exemple jusqu'à 2 000 m, particulièrement sur certains puits de forage pétroliers.

L'invention a donc pour objet un générateur électrique, du type comprenant des modules thermoélectriques fixés et isolés électriquement entre les deux parois d'un conduit séparant un fluide intérieur en mouvement et un fluide extérieur présentant une température différente de celle du fluide intérieur, caractérisé en ce que les modules thermoélectriques sont positionnés de manière telle que leurs surfaces d'échange thermique sont approximativement perpendiculaires à la direction de l'écoulement du fluide intérieur.

Selon une caractéristique avantageuse, les modules thermoélectriques sont positionnés sur chacune des deux faces d'une collerette appliquée radialement par serrage sur le conduit.

Dans un mode de réalisation, le générateur selon l'invention est caractérisé en ce qu'il comporte au moins un étrier annulaire enserrant et isolant électriquement du fluide extérieur au moins une collerette et les modules thermoélectriques qui y sont positionnés.

De préférence, le générateur comporte un empilage étanche de collerettes et d'étriers les enserrant, disposés le long du conduit.

D'autres avantages d'un générateur électrique selon la présente invention apparaîtront dans la description suivante d'un mode non limitatif de réalisation, en référence aux dessins annexés sur lesquels :
la figure 1 est une coupe longitudinale d'un générateur,
la figure 2 est une coupe suivant AA de la figure 1,
la figure 3 montre une coupe détaillée de réalisation selon AA de la figure 2,
la figure 4 schématise le montage électrique associé au générateur.

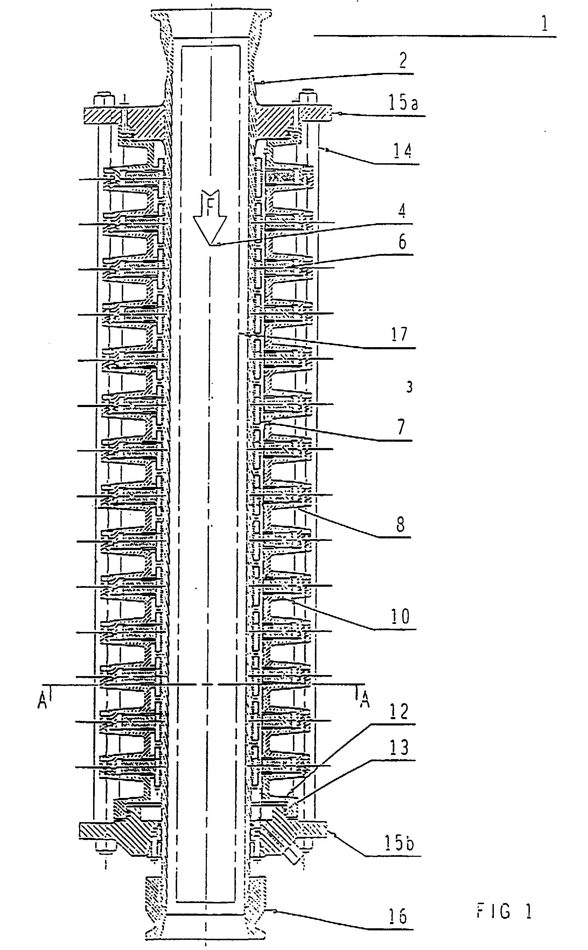

La figure 1 montre le générateur thermoélectrique présentant la forme générale d'un manchon 1 autour d'une canalisation ou conduit 2 appartenant à une tête de puits, non représentée, immergée dans l'eau de mer 3. Le conduit 2 contient du produit liquide 4, ici de l'huile, extrait par forage, circulant par exemple dans le sens de la flèche F.

Le manchon se compose d'un tube central 2, par exemple en acier, sur lequel sont fixées radialement des collerettes 6, par exemple en cuivre. Les collerettes sont maintenues sur le tube central par un système connu de vis à coins 7 placé le long du conduit. Sur chaque face d'une collerette 6, on dispose des modules thermoélectriques 8. Ceux-ci, par exemple au nombre de 13 sur chaque face, sont répartis régulièrement, près de la partie périphérique de la collerette 6. Ceux-ci sont câblés en série et connectés au câble 5.

Chaque module thermoélectrique est, de façon connue, un assemblage plan de thermocouples en série à base de semiconducteurs. Les faces 8a et 8b permettant l'échange thermique sont donc disposées perpendiculairement au sens de l'écoulement F du liquide circulant dans le conduit 2.

Les modules thermoélectriques 8, connus en eux-mêmes, sont choisis en tenant compte de leurs dimensions (longueur, largeur, épaisseur), du nombre de couples par module, et essentiellement du rapport surface sur épaisseur du thermoélément constitutif (type N ou P) formant un demi-couple. On privilégie une épaisseur faible conduisant à une résistance interne faible. Par exemple, on utilise des thermoéléments qui ont la forme de plaquettes rectangulaires d'environ 60 sur 30 mm, présentant 254 thermocouples au tellurure de bismuth, permettant un fonctionnement jusqu'à une température de 300°C, avec un rapport surface sur épaisseur de 0,079 cm.

Un isolant électrique entoure chaque collerette, et les modules thermoélectriques sont séparés par un isolant thermique et électrique 9 pour concentrer le flux à travers les modules.

Deux collerettes 6 adjacentes sont recouvertes extérieurement par un étrier annulaire 10, par exemple en cupro-aluminium. Deux étriers successifs en forme de U présentant des rebords supérieurs extérieurs, 10a et 10b, sont serrés l'un sur l'autre par des vis 11.

Les étriers 12 d'extrémité présentent un profil particulier : un joint 13 possède un diamètre extérieur de dimension telle que la contrainte exercée sur chacun des modules thermoélectriques 8 par l'intermédiaire d'un étrier 10 lorsque ce dernier est soumis à une pression externe, par exemple celle due à l'immersion sous-marine, est indépendante de la valeur de cette pression. Ainsi, le générateur selon l'invention est adapté à un fonctionnement à grande profondeur sous-marine.

L'ensemble forme alors un empilage disposé le long du conduit 2.

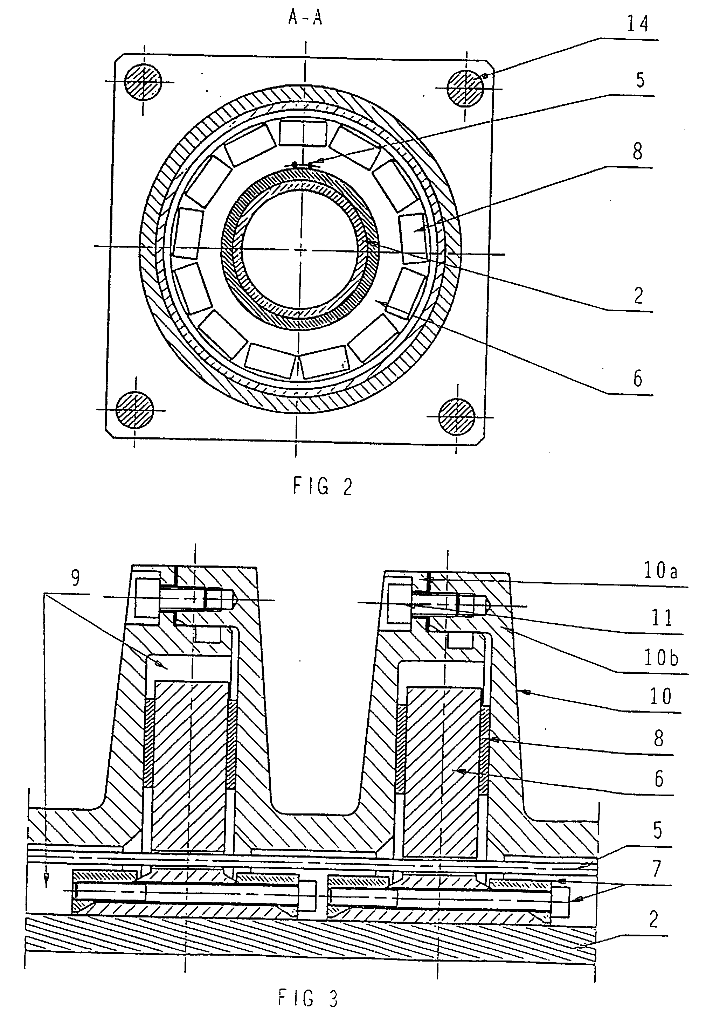

Afin de maintenir longitudinalement cet empilage, on prévoit des barres de compression 14, par exemple au nombre de quatre (voir figure 2), venant s'appuyer par des moyens de serrage connus, aux quatre coins de pièces d'extrémité 15a, 15b. Celles-ci assurent ainsi la fermeture et l'étanchéité de l'empilage.

L'une des pièces de fermeture d'extrémités, par exemple supérieure 15a sur la figure 1, est solidarisée, par soudage ou autre moyen, sur la paroi externe du conduit 2, tandis que l'autre pièce d'extrémité, par exemple 15b, est seulement bloquée en rotation sur la paroi externe du conduit 2, par exemple par un système de vis à coins pour que l'ensemble des barres de compression reste axial.

Cette pièce 15b reste toutefois libre longitudinalement, de manière à éviter la déformation des barres de compression.

Enfin, le générateur électrique constitué par le manchon ou l'empilage décrits plus haut est fixé sur le pipe ou conduit 2 par un système de bride 16, c'est-à-dire un raccord démontable situé du côté de la pièce d'extrémité 15b non solidarisée au conduit 2.

Le circuit d'alimentation des équipements d'une tête de puits de forage est complété par les dispositions suivantes.

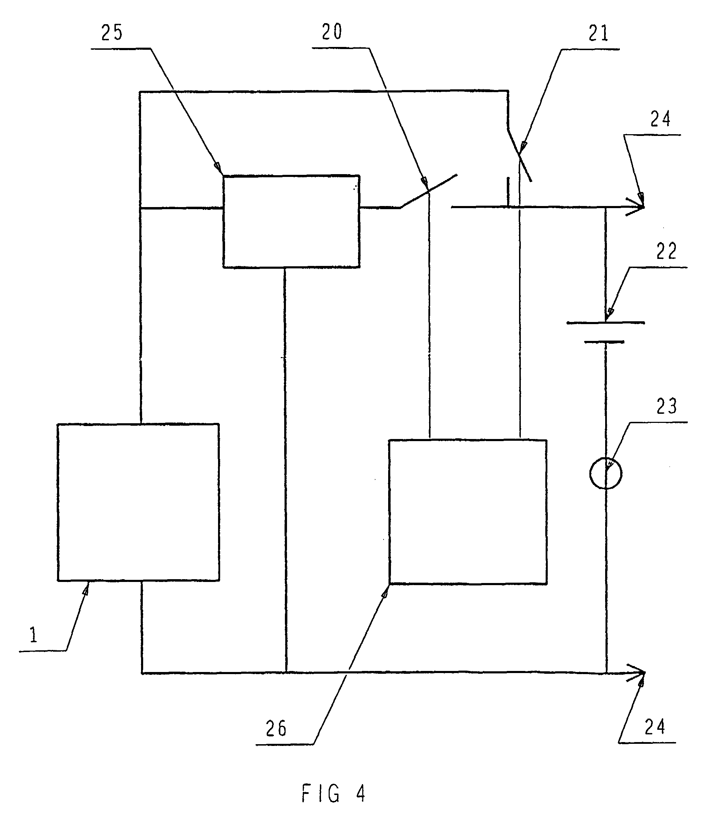

En référence à la figure 4, le générateur thermoélectrique 1 est relié électriquement, par deux contacteurs 20 et 21, à une batterie 22, par exemple au plomb à électrolyte gélifié, l'hydrogène dégagé étant éliminé soit par catalyse, soit directement évacué dans l'eau de mer, logée en caisson étanche ou en équipression, aux bornes de laquelle on dispose un capteur de courant 23, pour alimenter un réseau 24. Le circuit comprend un régulateur 25 et un coffret de traitement 26 pour la commande des contacteurs.

En fonctionnement normal, c'est à dire lorsque la puissance demandée est de l'ordre de 100 watts, le contacteur 20 est fermé et le contacteur 21 est ouvert. Le générateur thermoélectrique 1 débite à l'entrée du régulateur 25 qui maintient la batterie 22 en floating sous tension constante, par exemple de l'ordre de 17,6 V. Ainsi le réseau est alimenté sous tension constante, ce qui limite la consommation d'énergie et assure une grande autonomie, jusqu'à 5 ans, sans entretien.

Une puissance beaucoup plus importante sollicitée momentanémeni, 1000 watts par exemple, implique la mise en oeuvre du régulateur et de la batterie.

En cas de perte de puissance du générateur thermoélectrique, par exemple par suppression de la circulation de l'huile chaude dans le conduite 2, le contacteur 20 est ouvert et le contacteur 21 est lui aussi ouvert : seule la batterie reste opérationnelle. Au redémarrage de la source chaude, la batterie peut être rechargée par le régulateur ou par le générateur thermoélectrique suivant son niveau de décharge, en commandant judicieusement les contacteurs 20 et 21 par traitement des informations prenant en compte la valeur de la tension de sortie par l'intermédiaire du coffret de traitement 26.

Dans la mesure où la puissance nominale demandée sur le réseau n'est pas consommée en continu, le générateur thermoélectrique produit le complément d'énergie pour charger la batterie d'accumulateurs pouvant fournir la puissance demandée.

Les performances du générateur thermoélectrique ainsi décrit sont les suivantes : le fluide interne chaud est constitué d'huile circulant dans un pipe, d'un diamètre de 150 mm, à une température d'environ 60°C, à un débit d'environ 500 m³ par jour. Le fluide extérieur froid est de l'eau de mer à 4°C, circulant à une vitesse maximum de 1 m/s.

On dispose 26 modules thermoélectriques sur chaque collerette (13 sur chaque face), et on empile 26 étages de collerettes en un manchon présentant une longueur de 1,7 m. On obtient ainsi une puissance de 170 watts, soit 100 watts par unité de longueur de manchon.

Du fait de la protection cathodique et du choix du matériau (cupro-aluminium) constituant les collerettes, le risque de corrosion est minimisé. L'entartrage externe peut être évité par un revêtement de peinture. L'encrassement interne peut être supprimé par des moyens connus 17, placés sur la paroi interne du conduit où circule le fluide intérieur, c'est-à-dire l'huile, pour à la fois perturber la vitesse d'écoulement et augmenter les échanges thermiques entre le fluide intérieur et cette paroi interne.

Le générateur selon l'invention présente une grande compacité, ce qui permet de le loger facilement sur une tête de forage pétrolier.

## Revendications

1. Générateur électrique, du type comprenant des modules thermoélectriques (8) fixés et isolés électriquement entre les deux parois d'un conduit (2) séparant un fluide intérieur (4) en mouvement et un fluide extérieur (3) présentant une température différente de celle du fluide intérieur, caractérisé en ce que les modules thermoélectriques (8) sont positionnés de manière telle que leurs surfaces d'échange thermique sont approximativement perpendiculaires à la direction de l'écoulement (F) du fluide intérieur.

2. Générateur selon la revendication 1, caractérisé en ce que les modules thermoélectriques (8) sont positionnés sur chacune des deux faces d'une collerette (6) appliquée radialement par serrage sur le conduit (2).

3. Générateur selon la revendication 2, caractérisé en ce qu'il comporte au moins un étrier annulaire (10) enserrant et isolant électriquement du fluide extérieur au moins une collerette et les modules thermoélectriques qui y sont positionnés.

4. Générateur selon la revendication 3, caractérisé en ce qu'il comporte un empilage étanche de collerettes et d'étriers les enserrant, disposés le long du conduit.

5. Générateur selon la revendication 4, caractérisé en ce que l'espace défini entre l'empilage étanche et les modules thermoélectriques est rempli d'un produit isolant (9) thermiquement et électriquement.

6. Générateur selon la revendication 4, caractérisé en ce que les étriers annulaires d'extrémité (12) de l'empilage étanche sont dimensionnés de manière telle que la contrainte exercée sur les modules thermoélectriques par l'intermédiaire des étriers disposés le long de l'empilage et soumis à une pression externe, soit indépendante de la valeur de cette pression.

7. Générateur selon la revendication 4, caractérisé en ce qu'il comporte des barres de compression (14) disposées axialement à la périphérie des collerettes et sur lesquelles viennent s'appuyer deux pièces extrêmes (15a, 15b) de fermeture de l'empilage.

8. Générateur selon la revendication 7, caractérisé en ce que l'une des pièces de fermeture (15a) est solidarisée au conduit, l'autre (15b) étant au moins bloquée en rotation par rapport à celui-ci, de manière telle que les barres de compression (14) restent axiales.

9. Générateur selon la revendication 8, caractérisé en ce qu'il comporte un raccord (16) démontable situé du côté de la pièce de fermeture non solidarisée au conduit.

10. Générateur selon la revendication 1, caractérisé en ce que le conduit comporte des moyens (17) d'augmentation d'échanges thermiques entre le fluide intérieur et la paroi interne du conduit.

11. Application du générateur selon l'une quelconque des revendications précédentes à l'alimentation électrique des équipements d'une tête de forage.

12. Générateur électrique sous-marin selon l'une quelconque des revendications 1 à 10, caractérisé en ce qu'il est couplé en parallèle à une batterie (22) résistant à la pression sous-marine, par un circuit comportant notamment deux contacteurs (20, 21), un régulateur (25) et un coffret de traitement (26).

## Claims

1. An electric generator, of the type comprising thermoelectric cells 8 electrically attached and insulated between both walls of a duct 2 separating a moving internal fluid 4 and an external fluid 3, having a temperature different from that of the internal fluid, characterised in that the thermoelectric cells 8 are positioned in such a way that their surface of thermal exchange are approximately perpendicular to the outflow direction F of the internal fluid.

2. A generator according to claim 1 characterised in that thermoelectric cells 8 are positioned on both faces of a flared flange 6 radially clamped on duct 2.

3. A generator according to claim 2 characterised in that it comprises at least one annular clip 10 clamping and electrically insulating at least one flared flange and the positioned thermoelectric cells from the external fluid.

4. A generator according to claim 3 characterised in that it comprises a sealed stack of flared flanges and clamping clips, located along the duct.

5. A generator according to claim 4 characterised in that the space defined between the tight stack and the thermoelectric cells is filled with a thermally and electrically insulating product 9.

6. A generator according to claim 4 characterised in that annular clips 12 at the end of the tight stack are dimensioned in such a way that the stress exerted on the thermoelectric modules by the clips arranged along the stack and subjected to an external pressure, is independent of the value of this pressure.

7. A generator according to claim 4 characterised in that it comprises forcing levers 14 axially located at the flared flange periphery and on which two end parts 15a, 15b closing the stack rest.

8. A generator according to claim 7 characterised in that one of the closing parts 15a is solid with the duct, the other one 15b being at least blocked in rotation in relation to the latter, in such a way that the forcing levers 14 remain axial.

9. A generator according to claim 8 characterised in that it comprises a dismountable connection 16 located on the side of the closing part which is not solid with the duct.

10. A generator according to claim 1 characterised in that the duct comprises means 17 to increase the thermal exchanges between the internal fluid and the internal wall of the duct.

11. Application of the generator according to any of the previous claims to the power supply of the equipment of a drilling head.

12. An underwater electric generator according to any of the previous claims, characterised in that it is coupled in parallel to a battery 22 resisting underwater pressure, by means of a circuit notably comprising two contactors 20, 21, a régulator 25 and a processing cubicle 26.

## Patentansprüche

1. Elektrischer Stromerzeuger vom Typ mit thermoelektrischen Modulen (8), die zwischen den beiden Wänden einer Rohrleitung (2), welche eine sich bewegende innere Flüssigkeit (4) von einer Außenflüssigkeit (3), deren Temperatur sich von der Temperatur der inneren Flüssigkeit unterscheidet, abtrennen, befestigt und elektrisch isoliert sind, dadurch gekennzeichnet, dass die thermoelektrischen Module (8) so angeordnet sind, dass deren Wärmeaustauschflächen annähernd senkrecht zur Fließrichtung (F) der inneren Flüssigkeit liegen.

2. Stromerzeuger gemäß Patentanspruch 1, dadurch gekennzeichnet, dass die thermoelektrischen Module (8) an beiden Seiten eines radial an der Rohrleitung (2) befestigten Flansches (6) angebracht sind.

3. Stromerzeuger gemäß Patentanspruch 2, dadurch gekennzeichnet, dass er mit mindestens einem ringförmigen Bügel (10) ausgestattet ist, welcher mindestens einen Flansch und die thermoelektrischen Module, die darauf angebracht sind, umschließt und elektrisch von der Außenflüssigkeit isoliert.

4. Stromerzeuger gemäß Patentanspruch 3, dadurch gekennzeichnet, dass er mit einer wasserdichten Stapelung von Flanschen und diese umschließenden Bügeln, welche entlang der Rohrleitung angeordnet sind, ausgestattet ist.

5. Stromerzeuger gemäß Patentanspruch 4, dadurch gekennzeichnet, dass der zwischen der wasserdichten Stapelung und den thermoelektrischen Modulen definierte Zwischenraum mit einem thermisch und elektrisch isolierenden Produkt (9) gefüllt ist.

6. Stromerzeuger gemäß Patentanspruch 4, dadurch gekennzeichnet, dass die ringförmigen Endbügel (12) der wasserdichten Stapelung so dimensioniert sind, dass die über die entlang der Stapelung angeordneten und einem äußeren Druck ausgesetzten Bügel auf die thermoelektrischen Module ausgeübte Belastung vom Wert dieses Drucks unabhängig ist.

7. Stromerzeuger gemäß Patentanspruch 4, dadurch gekennzeichnet, dass er mit axial zum Umfang der Flansche angeordneten Druckstangen (14) ausgestattet ist, auf welchen zwei Endstücke (15a, 15b) als Stapelschlußelemente aufliegen.

8. Stromerzeuger gemäß Patentanspruch 7, dadurch gekennzeichnet, dass eines der Endstücke (15a) fest an der Rohrleitung befestigt ist, während das andere (15b) gegenüber dieser Rohrleitung mindestens in der Rotation blockiert ist, so dass die Druckstangen (14) ihre Axialposition beibehalten.

9. Stromerzeuger gemäß Patentanspruch 8, dadurch gekennzeichnet, dass er mit einem abmontierbaren, an der Seite des mit der Rohrleitung nicht fest verbundenen Endstücks angeordneten Verbindungselement (16) ausgestattet ist.

10. Stromerzeuger gemäß Patentanspruch 1, dadurch gekennzeichnet, dass die Rohrleitung mit Mitteln (17) zum Erhöhen der Wärmeaustausche zwischen der inneren Flüssigkeit und der Innenwand der Rohrleitung ausgestattet ist.

11. Anwendung des Stromerzeugers gemäß irgendeinem der vorstehenden Patentansprüche für die Energieversorgung der Ausrüstungen eines Bohrkopfes.

12. Unterwasser-Stromerzeuger gemäß irgendeinem der Patentansprüche 1 bis 10, dadurch gekennzeichnet, dass er über einen mit insbesondere zwei Schaltern (20, 21), einem Regler (25) und einem Datenverarbeitungskasten (26) ausgestatteten Schaltkreis parallel an eine gegen den Unterwasserdruck widerstandsfähige Batterie (22) angeschlossen ist.
